# EUROPEAN PATENT SPECIFICATION

(11) **EP 3 982 128 B1**
(45) Date of publication and mention of the grant of the patent: **31.07.2024**
(21) Application number: 20200312.5
(22) Date of filing: 06.10.2020
(51) Int. Cl.: H04W 24/06, H04W 24/08, G01R 29/08

(54) **FIELD-TESTING METHOD FOR TESTING V2X COMMUNICATION OF VEHICLES IN A REAL-WORLD ENVIRONMENT**
FELDPRÜFUNGSVERFAHREN ZUR PRÜFUNG DER V2X-KOMMUNIKATION VON FAHRZEUGEN IN EINER REALEN UMGEBUNG
PROCÉDÉ D'ESSAI SUR LE TERRAIN POUR TESTER LA COMMUNICATION V2X DE VÉHICULES DANS UN ENVIRONNEMENT DU MONDE RÉEL

(43) Date of publication of application: 13.04.2022
(73) Proprietor: Rohde & Schwarz GmbH & Co. KG, 81671 München (DE)
(72) Inventor: Naseef, Mahmud, 82152 Planegg (DE)
(74) Representative: Novagraaf Group

(56) References cited:
- EP-A1- 3 709 034
- KR-A- 20190 072 437
- KR-B1- 101 941 855
- KR-B1- 102 055 385
- US-A1- 2011 130 135
- WANG JIAN ET AL: "A Survey of Vehicle to Everything (V2X) Testing", SENSORS, vol. 19, no. 2, 15 January 2019 (2019-01-15), pages 334, XP055781743, DOI: 10.3390/s19020334
- 5GAA AUTOMOTIVE ASSOCIATION: "5GAA V2X Functional and Performance Test Report", 11 April 2019 (2019-04-11), pages 1 - 135, XP055782073, Retrieved from the Internet <URL:https://5gaa.org/wp-content/uploads/2018/11/5GAA_P-190033_V2X-Functional-and-Performance-Test-Report_final-1.pdf> [retrieved on 20210304]
- FISCHER FRANCOIS ET AL: "D4.1: V2X development and test plan", 15 April 2019 (2019-04-15), pages 1 - 25, XP055782067, Retrieved from the Internet <URL:https://5gaa.org/wp-content/uploads/2018/11/5GAA_P-190033_V2X-Functional-and-Performance-Test-Report_final-1.pdf> [retrieved on 20210304]

## Description

### TECHNICAL FIELD

The present invention relates to a field-testing method for testing V2X communication of vehicles in a real-world environment.

### BACKGROUND

Modern cars are increasingly equipped with wireless communication devices, in particular for vehicle-to-everything (V2X) communication, on which basis information may be communicated from a vehicle to any entity that may affect the vehicle or that may be affected by it. Such a vehicular communication system may incorporate other more specific types of communication as V2I (vehicle-to-infrastructure), V2N (vehicle-to-network), V2V (vehicle-to-vehicle), V2P (vehicle-to-pedestrian), V2D (vehicle-to-device) and V2G (vehicle-to-grid). V2X technology does not only improve traffic flow but also may help to make traffic safer.

Recently, two competing technological approaches to V2X communications have been investigated, see for example M. Klapez et al., "Application-Level Performance of IEEE 802.11p in Safety-Related V2X Field Trials," in IEEE Internet of Things Journal, vol. 7, no. 5, pp. 3850-3860, May 2020. These divide into two families, namely dedicated short-range communications (DSRC) and cellular-V2X (C-V2X). The former is based on the IEEE 802.11 standard and the IEEE 802.11p amendments. The latter has been defined in the 4G LTE Release 14 specifications (LTE C-V2X) and is being investigated for the future 5G New Radio C-V2X (NR C-V2X) standards. C-V2X is believed to have a wider range of applications in areas, such as entertainment, traffic data, navigation, and, most notably, autonomous driving. Compared to DSRC, it can cover larger areas with less infrastructure equipment, possibly reducing the capital and operational expenditures for the infrastructure owners. From the prior art a document KR 2019 0072437 A is known which discloses a system and a method for testing a connected car and a V2X-applied autonomous cooperative road, performing analysis and evaluation of test scenarios based on generated virtual data, and testing a function and performance of a test vehicle and the autonomous cooperative road system.

In order to probe the basic network performance of these technologies, laboratory tests may be executed within a controlled environment, in particular a closed chamber under carefully prepared conditions. However, such lab tests may provide only limited insights on the effectiveness of the tested technology for the more general case of a realistic setting under real-world conditions.

### SUMMARY

Against this background, there is a need to provide practical solutions for field trials of V2X communications.

To this end, the present invention provides a field-testing method with the features of the independent claim.

According to an aspect of the invention, a field-testing method for testing V2X communication of vehicles in a real-world environment according to claim 1.

One idea of the present invention is to use an antenna setup in collaboration with a moving test vehicle to analyze and calibrate the real-world test area in terms of signal amplitude to ensure an acceptable V2X signal reception quality within the test area. To this end, a signal generator with sufficient signal strength is employed (with or without the help of a power amplifier) together with a vehicle communication antenna, which may be, for example, a mass-produced product. As a result, the power level of the test signal, in particular a V2X test signal, may be adjusted during this calibration run to provide an adequately uniform signal within the test area irrespective of the particular circumstances. This means that any influence of the environment can be factored in the test signal over the whole driving range of the test vehicle. As a consequence, the present invention facilitates the transition from a lab-testing approach to a field-testing approach in a pragmatic way. The invention may be used to test different V2x technologies, in particular V2V, that is, vehicle-to-vehicle communication.

Further embodiments of the present invention are subject of the subordinate claims and of the following description, referring to the drawings.

According to an embodiment, adapting the test signal may comprise signal amplification, signal modulation and/or superimposing interference signals.

For example, a signal amplifier may be provided as part of the signal generator, which may be configured to enhance the test signal to a sufficient signal strength. Additionally, or alternatively, destructively and/or constructively interfering signals may be switched on or off to achieve an acceptable reception quality at the testing positions, e.g. by employing an antenna array configuration as part of the signal-generating antenna. Moreover, various test signal modulations may be utilized to optimize the testing scenario with respect to signal quality, including but not limited to frequency modulation, amplitude modulation, phase modulation etc. The respective equipment may be integrated into the signal generator and/or the antenna system.

According to an embodiment, a two-dimensional amplitude map may be calculated on basis of the determined signal amplitudes of the vehicle communication antenna mapping the signal amplitude as a function of position within the real-world test area.

For example, the amplitude of the received V2X signal may be displayed as a heat map, which may then be used for displaying and/or optimizing the V2X signal across the testing area.

The testing grid may define a rectangular pattern of lines across the testing area, along which a plurality of measurement points is arranged in a regular way.

According to an embodiment, the method may further comprise measuring a signal amplitude of the adapted test signal at the testing positions within the real-world test area with a measurement antenna. The method may further comprise comparing the measured signal amplitudes of the measurement antenna with the signal amplitudes of the vehicle communication antenna at the testing positions.

Hence, after one (or several) calibration runs with the test vehicle, the correspondingly adapted and optimized V2X testing signal may be used in one (or several) subsequent measurement runs for the actual V2X testing. To this end, one or several V2X measurement antennas may be mounted, for example, on one or several vehicles, which may then travel around the V2X testing area in order to test and analyze V2X reception. In principle, the test vehicle used for the calibration run may also be equipped with the measurement antenna and be used for the subsequent measurement run.

According to an embodiment, the measurement antenna may be configured identical to the vehicle communication antenna.

Thus, for example, the same type of antenna may be used to calibrate and test V2X reception within the real-world test area. In one particular example, the antenna may be provided as part of an onboard unit (OBU) being embedded together with additional network equipment in a vehicle, e.g. a car, a truck, a utility vehicle or any other land vehicle.

Depending on the type of antenna, it may be beneficial to install an antenna inside the real-world test area or outside the real-world test area. In principle however, several antennas may be used in combination inside and outside the test area.

According to an embodiment, the signal-generating antenna system may comprise an omnidirectional antenna and/or an array of directional antennas.

For example, one or several omnidirectional antennas may be installed inside the real-world test area. In another example, a multitude of directional antennas may be placed at the border of or close-by to the real-world test area in order to cover the test area with the test signal.

An array configuration may be used, for example, to precondition the signal to add up constructively and/or destructively across the test area, e.g. at different grid points, to increase or decrease signal reception strength (signal amplitude) of the test signal along the test track followed by the test vehicle.

According to an embodiment, the signal-generating antenna system may comprise an array of horn antennas.

Horn antennas are widely used as directive antennas at UHF and microwave frequencies and typically comprise a metal waveguide shaped like a horn to direct electromagnetic waves in a beam. Their advantages comprise low standing wave ratio, broad bandwidth as well as simple construction and adjustment.

According to an embodiment, the signal-generating antenna system may comprise at least one antenna installed at the same height as the vehicle communication antenna of the calibration vehicle.

In this way, a line of sight situation may be accomplished between the calibration antenna and the signal-generating antenna, i.e. between transmitting and receiving antennas, thereby optimizing connectivity of the V2X communication.

According to an embodiment, the at least one antenna may be installed at a height between 1 m and 2 m above ground.

In one particular example, the at least one antenna may be installed at a height of about 1.5 m. It is to be understood however that other heights may be suitable depending on the particular application at hand. For example, a V2X antenna may be installed at different heights depending on the type of vehicle, e.g. a sports utility vehicle may require one or several antennas to be installed at a greater height than in a compact passenger vehicle.

According to an embodiment, the vehicle communication antenna may be connected to a spectrum analyzer, a frequency selective power sensor and/or a radio receiver capable of measuring a signal reception power tuned to the correct frequency.

According to an embodiment, the test signal may comprise a continuous wave signal and/or a modulated wide band signal.

According to an embodiment, the real-world test area may span an area between 0,001 km² and 10 km².

In one particular example, the real-world test area may be a rectangular area with sides each having a length of several hundred meters, e.g. 250 m times 250 m, 300 m times 300 m, and so on.

According to an embodiment, the real-world test area may be an outdoor area.

For example, the real-world test area may be an arbitrary area or part of a city or town, an urban or country district, a street section, a parking area and so on. It is to be understood however, that a real-world test area may not only include outdoor areas but may also comprise parking garages, tunnel sections and other roofed and/or underground areas, through which vehicles may drive. Real-world test areas within the meaning of the present invention are to be distinguished from a predefined laboratory setting, e.g. within a testing chamber.

### BRIEF DESCRIPTION OF THE DRAWINGS

For a more complete understanding of the present invention and advantages thereof, reference is now made to the following description taken in conjunction with the accompanying drawings. The invention is explained in more detail below using exemplary embodiments which are specified in the schematic figures of the drawings, in which:
- Fig. 1: shows a schematic diagram of a measurement arrangement for a field-testing method according to an embodiment of the present invention; and
- Fig. 2: shows a schematic flow diagram of the field-testing method used in Fig. 1;
- Fig. 3: shows an alternative measurement arrangement for the field-testing method of Fig. 2;
- Fig. 4: shows a testing grid of testing positions used in the field-testing methods of Figs. 1 to 3; and
- Fig. 5: shows the measuring arrangement of Fig. 1 in a side view.

The appended drawings are intended to provide further understanding of the embodiments of the invention. They illustrate embodiments and, in conjunction with the description, help to explain principles and concepts of the invention. Other embodiments and many of the advantages mentioned become apparent in view of the drawings. The elements in the drawings are not necessarily shown to scale.

In the drawings, like, functionally equivalent and identically operating elements, features and components are provided with like reference signs in each case, unless stated otherwise.

### DETAILED DESCRIPTION OF THE DRAWINGS

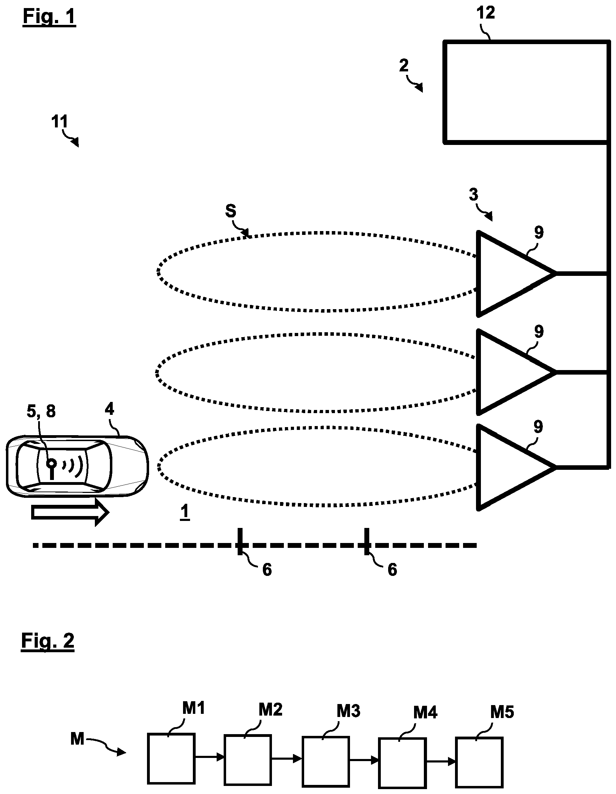

Figure 1 shows a schematic diagram of a measurement arrangement 11 for a field-testing method M according to an embodiment of the present invention. Fig. 2 depicts a schematic flow diagram of the field-testing method M used in Fig. 1.

The measuring arrangement 11 and field-testing method M are provided for testing V2X communication of vehicles in a real-world environment, e.g. an area covering one or several streets within an urban region. The method M as described below may be used to set up and calibrate a V2X signal across the respective area and then use this calibrated setting in a controlled manner for V2X test runs. In one particular example, the measuring arrangement 1 and the method M may be used to test V2V communication, i.e. communication between one vehicle and other vehicles, in an urban setting outside of well-known yet artificial lab settings.

In order to calibrate the V2X communication, the method M comprises under M1 sending a test signal S into a real-world test area 1, e.g. an urban outdoor area. To this end, the measurement arrangement 11 comprises a signal generator 2 with sufficient signal strength (e.g. 23dBm) and configured to generate the test signal S, e.g. a continuous wave signal. Specifically, the signal generator 2 comprises a signal-generating antenna system 3 configured to cover the real-world test area 1 with the test signal S. In the example of Fig. 1, the signal-generating antenna system 3 is installed bordering the real-world test area 1 and/or close-by to the real-world test area 1. The signal-generating antenna system 3 is stationary and comprises an array of directional antennas 9, each configured to send out the test signal S into a particular direction and region of the real-world test area 1 (cf. Fig. 1).

Each directional antenna 9 may, for example, be configured as a broadband horn antenna, e.g. a linear-polarized double-ridged horn antenna for the frequency range of roughly 1 GHz to 20 GHz. Such horn antennas are compact and provide a wide frequency range, high and flat gain and low VSWR (voltage standing wave ratio). These antennas are typically made of aluminum to keep the weight low. With such antennas it is possible to measure weak signals and generate high field strengths without any significant return loss. As schematically shown in Fig. 1, each directional antenna 9 may produce a single main lobe radiation pattern over the whole frequency range. Horn antennas may be configured such that their radiation pattern contains only a single main lobe over the entire frequency range without appreciable side lobes. It is to be understood however that different configurations may be used in alternative embodiments featuring more complex radiation patterns including various main lobes and/or side lobes.

In order to generate the test signal, the signal generator 2 further comprises a signal control device 12 coupled to the directional antennas 9. The signal control device 12 may comprise the usual equipment known to the person of skill and required for producing an adequate V2X antenna signal within the GHz range. For example, the signal control device 12 may include an antenna amplifier (not shown in Fig. 1) for boosting a GHz antenna signal to an output signal of convenient strength.

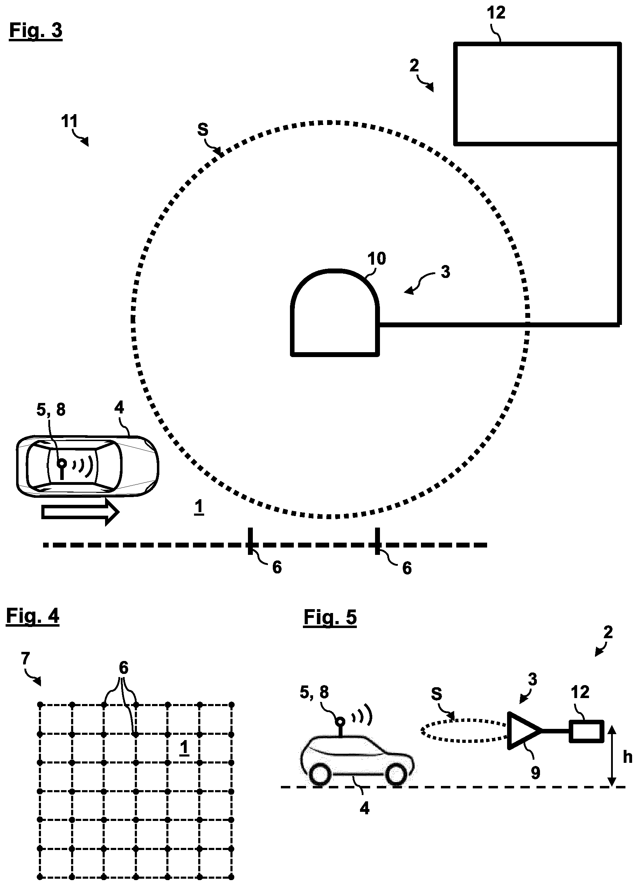

Again, referring to Fig. 2, the method M further comprises under M2 moving a calibration vehicle 4, e.g. a car, around the real-world test area 1. The calibration vehicle 4 is equipped with a vehicle communication antenna 5 configured to receive the test signal S. For example, the vehicle communication antenna 5 of the calibration vehicle 4 may be provided together with further network equipment as part of an onboard unit (OBU) on the calibration vehicle 4 (not shown in Fig. 1). In one particular example, the vehicle communication antenna 5 may be installed on top of the calibration vehicle 4, for example on a car roof. In order to achieve optimal signal reception, the directional antennas 9 of the signal generator 2 may be installed at a corresponding height h above ground, e.g. 1.5 m. An example for such a configuration is shown in Fig. 5.

Further referring to Fig. 2, the method M may comprise receiving the test signal S with the vehicle communication antenna 5 at testing positions 6 distributed over the real-world test area 1. To this end, a particular route may be defined in advance leading through the real-world test area 1. The calibration vehicle 4 may follow this route to reach one testing position 6 after the other until all predefined testing positions 6 have been passed.

In the depicted example, the testing positions 6 are defined along a grid 7 spanning across the real-world test area 1, cf. Fig. 4 as an example showing a schematic grid 7 defining a multitude of testing positions 6. The real-world test area 1 may span a certain area of an urban district, e.g. a square of 250 m times 250 m. The grid may divide this area in smaller squares, each square having one or several testing positions 6.

At each testing position 6, the calibration vehicle 4 may now try to receive the test signal S from the signal generator 2. Correspondingly, the method M comprises under M4 determining a signal amplitude of the test signal 2 received with the vehicle communication antenna 5 at the testing positions 6. The received test signal S may now be evaluated, e.g. immediately within a control unit of the vehicle 4 and/or the OBU of the vehicle 4. Alternatively, the test signal S may be analyzed at a later point in time after the vehicle 4 has finished the calibration ride across the real-world test area 1.

In one particular example, a two-dimensional amplitude map may be calculated on basis of the determined signal amplitudes of the vehicle communication antenna 5, which maps the signal amplitude as a function of position within the real-world test area 1. The amplitude map may then be displayed and used for evaluation purposes.

The usual tools may be employed to detect, extract and evaluate the V2X signal. For example, a spectrum analyzer may be employed to measure the magnitude of the input signal versus frequency and thereby determine the power of the signal spectrum. By analyzing various parameters of the received signals the employed antennas and the V2X communication may be characterized. Network parameters may be measured with a network analyzer based on reflection and transmission across the system.

Next, the method M comprises under M5 adapting the test signal S of the signal generator 2 based on the determined signal amplitudes of the vehicle communication antenna 5 such that the signal amplitude of the test signal S exceeds a predefined amplitude level across the real-world test area 1. For example, the test signal S may be adapted by the signal control device 12 by means of signal amplification and/or signal modulation. Additionally, or alternatively, the test signal S may also be adapted by superimposing interference signals in a destructive and/or constructive way. To this end, the signal control device 12 may rely on the antenna system 3 and potentially also other/additional equipment inside or outside the test area 1.

Thus, a multiple antenna setup is used to evaluate and adapt the test signal point by point across the testing grid 7, thereby mapping and optimizing the signal strength across the real-world test area 1 to an acceptable and uniform level as required for the particular scenario at hand. Particularities of the respective real-world environment can thus be taken into account in the setup on basis of a very practical and convenient procedure.

After one or several such calibration rides across the real-world test area 1, the actual testing of the V2X communication may now be performed. For example, the system may be tested for V2V communication.

To this end, the method M may further comprise measuring a signal amplitude of the adapted test signal S at the testing positions 6 within the real-world test area 1 with a measurement antenna 8. The measurement antenna 8 may be configured identical to the vehicle communication antenna 5, i.e. it may feature the same type of antenna mounted at the same or a similar height. The measurement antenna 8 may be mounted on a test vehicle different from the calibration vehicle 4. In principle however, the calibration vehicle 4 may also be used for one or several such measurement rides.

Next, the method M may then further comprise comparing the measured signal amplitudes of the measurement antenna 8 with the signal amplitudes of the vehicle communication antenna 5 at the testing positions 6. The results may be then be used to evaluate and study the V2X communication in a controlled manner despite the real-world environment.

The exemplary embodiment of Figs. 1 and 5 relies on directional antennas 9. However, alternatively, or additionally, one or several broadband omnidirectional antennas may be used, e.g. a linearly polarized omnidirectional antenna covering a frequency range from roughly 1 GHz to 20 GHz. Also these kinds of antennas may be provided with compact dimensions, high efficiency and a robust design and may be employed as a transmitting antenna primarily designed to transmit low-power test signals. For example, using a low-attenuation, weatherproof radome, reliable operation of the antenna may be ensured even in harsh environments.

With reference to Fig. 3, an alternative measuring arrangement 11 is shown that utilizes such an omnidirectional antenna 10. In this example, the omnidirectional antenna 10 is installed inside the real-world test area 1 and transmits the test signal S uniformly in all directions outwards. It will be clear to the person of skill that various other antenna configurations and arrangements may be utilized for the above purposes including combinations of directional, omnidirectional, stationary, mobile etc. antennas.

The invention is defined by the appended claims.

### List of reference signs

- 1: real-world test area
- 2: signal generator
- 3: antenna system
- 4: calibration vehicle
- 5: vehicle communication antenna
- 6: testing position
- 7: testing grid
- 8: measurement antenna
- 9: directional antenna
- 10: omnidirectional antenna
- 11: measurement arrangement
- 12: signal control device
- S: test signal
- h: height
- M: method
- M1-M5: method steps

## Claims

1. Field-testing method (M) using an antenna setup in collaboration with a moving test vehicle to analyze and calibrate a real-world test area (1) for testing V2X communication of vehicles in a real-world environment, the method (M) comprising:
sending (M1) a test signal (S) into the real-world test area (1) with a signal generator (2), the signal generator (2) comprising a signal-generating antenna system (3) configured to cover the real-world test area (1) with the test signal (S), the signal-generating antenna system (3) comprising at least one stationary antenna (9, 10) installed within and/or around the real-world test area (1);
moving (M2) a calibration vehicle (4) around the real-world test area (1), the calibration vehicle (4) being equipped with a vehicle communication antenna (5) configured to receive the test signal (S);
receiving (M3) the test signal (S) with the vehicle communication antenna (5) at testing positions (6) distributed over the real-world test area (1), wherein the testing positions (6) are defined as a testing grid (7) across the real-world test area;
determining (M4) a signal amplitude of the test signal (S) received with the vehicle communication antenna (5) at the testing positions (6); and
adapting (M5) the test signal (S) of the signal generator (2) based on the determined signal amplitudes of the vehicle communication antenna (5) such that the signal amplitude of the test signal (S) exceeds a predefined amplitude level across the real-world test area (1).

2. Method (M) according to claim 1, wherein adapting the test signal (S) comprises at least one of signal amplification, signal modulation and superimposing interference signals.

3. Method (M) according to claim 1 or 2, wherein a two-dimensional amplitude map is calculated on basis of the determined signal amplitudes of the vehicle communication antenna (5) mapping the signal amplitude as a function of position within the real-world test area (1).

4. Method (M) according to one of the claims 1 to 3, further comprising:
measuring a signal amplitude of the adapted test signal (S) at the testing positions (6) within the real-world test area (1) with a measurement antenna (8); and
comparing the measured signal amplitudes of the measurement antenna (8) with the signal amplitudes of the vehicle communication antenna (5) at the testing positions (6).

5. Method (M) according to claim 4, wherein the measurement antenna (8) is configured identical to the vehicle communication antenna (5).

6. Method (M) according to one of the claims 1 to 5, wherein the signal-generating antenna system (3) comprises at least one of an omnidirectional antenna (10) and an array of directional antennas (9).

7. Method (M) according to one of the claims 1 to 6, wherein the signal-generating antenna system (3) comprises an array of horn antennas.

8. Method (M) according to one of the claims 1 to 7, wherein the signal-generating antenna system (3) comprises at least one antenna (9, 10) installed at the same height (h) as the vehicle communication antenna (5) of the calibration vehicle (4).

9. Method (M) according to claim 8, wherein the at least one antenna (9, 10) is installed at a height (h) between 1 m and 2 m above ground.

10. Method (M) according to one of the claims 1 to 9, wherein the vehicle communication antenna is connected to at least one of a spectrum analyzer, a frequency selective power sensor and a radio receiver capable of measuring a signal reception power tuned to the correct frequency.

11. Method (M) according to one of the claims 1 to 10, wherein the test signal (S) comprises at least one of a continuous wave signal and a modulated wide band signal.

12. Method (M) according to one of the claims 1 to 11, wherein the real-world test area (1) spans an area between 0,001 km² and 10 km².

13. Method (M) according to one of the claims 1 to 12, wherein the real-world test area (1) is an outdoor area.

## Patentansprüche

1. Feldtestverfahren (M) unter Verwendung eines Antennenaufbaus in Zusammenarbeit mit einem fahrenden Testfahrzeug, um ein Realwelttestgelände (1) zum Testen einer V2X-Kommunikation von Fahrzeugen in einer Realweltumgebung zu analysieren und kalibrieren, das Verfahren (M) umfassend:
Senden (M1) eines Testsignals (S) in das Realwelttestgelände (1) mit einem Signalgenerator (2), der Signalgenerator (2) umfassend ein signalgenerierendes Antennensystem (3), das konfiguriert ist, um das Realwelttestgelände (1) mit dem Testsignal (S) abzudecken, das signalgenerierende Antennensystem (3) umfassend mindestens eine stationäre Antenne (9, 10), die innerhalb und/oder um das Realwelttestgelände (1) installiert ist;
Bewegen (M2) eines Kalibrierungsfahrzeugs (4) um das Realwelttestgelände (1), wobei das Kalibrierungsfahrzeug (4) mit einer Fahrzeugkommunikationsantenne (5) ausgestattet ist, die konfiguriert ist, um das Testsignal (S) zu empfangen;
Empfangen (M3) des Testsignals (S) mit der Fahrzeugkommunikationsantenne (5) an Testpositionen (6), die über das Realwelttestgelände (1) verteilt sind, wobei die Testpositionen (6) als ein Testraster (7) über das Realwelttestgelände hinweg definiert sind;
Bestimmen (M4) einer Signalamplitude des Testsignals (S), das mit der Fahrzeugkommunikationsantenne (5) an den Testpositionen (6) empfangen wird; und
Anpassen (M5) des Testsignals (S) des Signalgenerators (2) basierend auf den bestimmten Signalamplituden der Fahrzeugkommunikationsantenne (5) derart, dass die Signalamplitude des Testsignals (S) über das Realwelttestgelände (1) hinweg einen vordefinierten Amplitudenpegel überschreitet.

2. Verfahren (M) nach Anspruch 1, wobei das Anpassen des Testsignals (S) mindestens eines von einer Signalverstärkung, einer Signalmodulation und einem Überlagern von Störsignalen umfasst.

3. Verfahren (M) nach Anspruch 1 oder 2, wobei auf einer Basis der bestimmten Signalamplituden der Fahrzeugkommunikationsantenne (5) eine zweidimensionale Amplitudenabbildung berechnet wird, die die Signalamplitude als Funktion einer Position innerhalb des Realwelttestgeländes (1) abbildet.

4. Verfahren (M) nach einem der Ansprüche 1 bis 3, ferner umfassend:
Messen einer Signalamplitude des angepassten Testsignals (S) an den Testpositionen (6) innerhalb des Realwelttestgeländes (1) mit einer Messantenne (8); und
Vergleichen der gemessenen Signalamplituden der Messantenne (8) mit den Signalamplituden der Fahrzeugkommunikationsantenne (5) an den Testpositionen (6).

5. Verfahren (M) nach Anspruch 4, wobei die Messantenne (8) zu der Fahrzeugkommunikationsantenne (5) identisch konfiguriert ist.

6. Verfahren (M) nach einem der Ansprüche 1 bis 5, wobei das signalgenerierende Antennensystem (3) mindestens eine Rundstrahlantenne (10) und/oder ein Array von Richtantennen (9) umfasst.

7. Verfahren (M) nach einem der Ansprüche 1 bis 6, wobei das signalgenerierende Antennensystem (3) ein Array von Hornantennen umfasst.

8. Verfahren (M) nach einem der Ansprüche 1 bis 7, wobei das signalgenerierende Antennensystem (3) mindestens eine Antenne (9, 10) umfasst, die auf gleicher Höhe (h) wie die Fahrzeugkommunikationsantenne (5) des Kalibrierungsfahrzeugs (4) installiert ist.

9. Verfahren (M) nach Anspruch 8, wobei die mindestens eine Antenne (9, 10) in einer Höhe (h) zwischen 1 m und 2 m über dem Boden installiert wird.

10. Verfahren (M) nach einem der Ansprüche 1 bis 9, wobei die Fahrzeugkommunikationsantenne mit mindestens einem von einem Spektrumanalysator, einem frequenzselektiven Leistungssensor und einem Funkempfänger verbunden ist, der in der Lage ist, eine Signalempfangsleistung zu messen, die auf die richtige Frequenz abgestimmt ist.

11. Verfahren (M) nach einem der Ansprüche 1 bis 10, wobei das Testsignal (S) mindestens eines von einem Dauerstrichsignal und einem modulierten Breitbandsignal umfasst.

12. Verfahren (M) nach einem der Ansprüche 1 bis 11, wobei das Realwelttestgelände (1) ein Gelände zwischen 0,001 km² und 10 km² umfasst.

13. Verfahren (M) nach einem der Ansprüche 1 bis 12, wobei das Realwelttestgelände (1) ein Außengelände ist.

## Revendications

1. Procédé d'essai sur le terrain (M) à l'aide d'une configuration d'antenne en collaboration avec un véhicule d'essai en déplacement pour analyser et calibrer une zone d'essai en conditions réelles (1) afin de tester la communication V2X des véhicules dans un environnement réel, le procédé (M) comprenant :
l'envoi (M1) d'un signal d'essai (S) dans la zone d'essai en conditions réelles (1) à l'aide d'un générateur de signaux (2), le générateur de signaux (2) comprenant un système d'antennes de génération de signaux (3) configuré pour couvrir la zone d'essai en conditions réelles (1) avec le signal d'essai (S), le système d'antennes de génération de signaux (3) comprenant au moins une antenne stationnaire (9, 10) installée à l'intérieur et/ou autour de la zone d'essai en conditions réelles (1) ;
le déplacement (M2) d'un véhicule de calibrage (4) autour de la zone d'essai en conditions réelles (1), le véhicule de calibrage (4) étant équipé d'une antenne de communication du véhicule (5) configurée pour recevoir le signal d'essai (S) ;
la réception (M3) du signal d'essai (S) à l'aide de l'antenne de communication du véhicule (5) au niveau des positions d'essai (6) réparties sur la zone d'essai en conditions réelles (1), dans lequel les positions d'essai (6) sont définies comme une grille d'essai (7) sur la zone d'essai en conditions réelles ;
la détermination (M4) d'une amplitude de signal du signal d'essai (S) reçu à l'aide de l'antenne de communication du véhicule (5) au niveau des positions d'essai (6) ; et
l'adaptation (M5) du signal d'essai (S) du générateur de signaux (2) en fonction des amplitudes du signal déterminées de l'antenne de communication du véhicule (5) de sorte que l'amplitude de signal du signal d'essai (S) dépasse un niveau d'amplitude prédéfini dans la zone d'essai en conditions réelles (1).

2. Procédé (M) selon la revendication 1, dans lequel l'adaptation du signal d'essai (S) comprend au moins l'une parmi l'amplification du signal, la modulation du signal et la superposition de signaux d'interférence.

3. Procédé (M) selon la revendication 1 ou 2, dans lequel une carte d'amplitude bidimensionnelle est calculée sur la base des amplitudes de signal du signal déterminées de l'antenne de communication du véhicule (5) en cartographiant l'amplitude du signal en fonction de la position dans la zone d'essai en conditions réelles (1).

4. Procédé (M) selon l'une des revendications 1 à 3, comprenant en outre :
la mesure de l'amplitude de signal du signal d'essai adapté (S) au niveau des positions d'essai (6) dans la zone d'essai en conditions réelles (1) à l'aide d'une antenne de mesure (8) ; et
la comparaison des amplitudes de signal mesurées de l'antenne de mesure (8) avec les amplitudes de signal du signal de l'antenne de communication du véhicule (5) au niveau des positions d'essai (6).

5. Procédé (M) selon la revendication 4, dans lequel l'antenne de mesure (8) est configurée de manière identique à l'antenne de communication du véhicule (5).

6. Procédé (M) selon l'une des revendications 1 à 5, dans lequel le système d'antennes de génération de signaux (3) comprend au moins l'un parmi une antenne omnidirectionnelle (10) et un réseau d'antennes directionnelles (9).

7. Procédé (M) selon l'une des revendications 1 à 6, dans lequel le système d'antennes de génération de signaux (3) comprend un réseau d'antennes cornets.

8. Procédé (M) selon l'une des revendications 1 à 7, dans lequel le système d'antennes de génération de signaux (3) comprend au moins une antenne (9, 10) installée à la même hauteur (h) que l'antenne de communication du véhicule (5) du véhicule de calibrage (4).

9. Procédé (M) selon la revendication 8, dans lequel l'au moins une antenne (9, 10) est installée à une hauteur (h) comprise entre 1 m et 2 m au-dessus du sol.

10. Procédé (M) selon l'une des revendications 1 à 9, dans lequel l'antenne de communication du véhicule est connectée à au moins l'un parmi un analyseur de spectre, un capteur de puissance à fréquence sélective et un récepteur radio capable de mesurer la puissance de réception d'un signal ajusté à la bonne fréquence.

11. Procédé (M) selon l'une des revendications 1 à 10, dans lequel le signal d'essai (S) comprend au moins l'un parmi un signal à ondes continues et un signal modulé à large bande.

12. Procédé (M) selon l'une des revendications 1 à 11, dans lequel la zone d'essai en conditions réelles (1) s'étend sur une zone comprise entre 0,001 km² et 10 km².

13. Procédé (M) selon l'une des revendications 1 à 12, dans lequel la zone d'essai en conditions réelles (1) est une zone extérieure.
